(19) Europäisches Patentamt

European Patent Office

Office européen des brevets

(11) **EP 1 555 701 A2**

(12) **EUROPÄISCHE PATENTANMELDUNG**

(43) Veröffentlichungstag:
**20.07.2005 Patentblatt 2005/29**

(51) Int Cl.[7]: **H01L 51/20**

(21) Anmeldenummer: **05000611.3**

(22) Anmeldetag: **13.01.2005**

(84) Benannte Vertragsstaaten:
**AT BE BG CH CY CZ DE DK EE ES FI FR GB GR HU IE IS IT LI LT LU MC NL PL PT RO SE SI SK TR**
Benannte Erstreckungsstaaten:
**AL BA HR LV MK YU**

(30) Priorität: **16.01.2004 DE 102004002587**

(71) Anmelder: **Novaled GmbH**
**01307 Dresden (DE)**

(72) Erfinder:
• **Leo, Karl, Dr.**
**01219 Dresden (DE)**
• **Schneider, Oliver**
**01097 Dresden (DE)**

(74) Vertreter: **Bittner, Thomas L., Dr.**
**Forrester & Boehmert**
**Pettenkoferstrasse 20-22**
**80336 München (DE)**

(54) **Bildelement für eine Aktiv-Matrix-Anzeige**

(57) Die Erfindung betrifft ein Bildelement für eine Aktiv-Matrix-Anzeige mit einer organischen Leuchtdiode (OLED) (19-23) und einer Treiberschaltung mit einem die Leuchtdiode (19-23) ansteuernden Treibertransistor und einem Kondensator, wobei ein stromführender Pfad des Treibertransistors in Reihe mit der Leuchtdiode (19-23) und zumindest mittelbar zwischen zwei Pole einer Betriebsspannungsquelle geschaltet ist. Eine Transportschicht (20) der Leuchtdiode (19-23) weist eine die elektrische Leitfähigkeit der Transportschicht (20) erhöhende Dotierung auf und ist mit dem Drain-Kontakt (15) des Treibertransistors elektrisch verbunden.

EP 1 555 701 A2

**Beschreibung**

Die Erfindung betrifft ein Bildelement für eine Aktiv-Matrix-Anzeige mit einer organischen Leuchtdiode (OLED) und einer Treiberschaltung mit einem die Leuchtdiode ansteuernden Treibertransistor, der mit seinem stromführenden Pfad in Reihe mit der Leuchtdiode und zumindest mittelbar zwischen zwei Polen einer Betriebsspannungsquelle geschaltet ist, und einem Kondensator.

Stand der Technik

OLED sind aussichtsreiche Kandidaten für die Herstellung großflächiger Anzeigen seit der Demonstration effizienter Bauelemente durch Tang et al. im Jahr 1987 (C.W. Tang et al., Appl. Phys. Lett. 51 (12), 913 (1987)). OLED umfaßt eine Folge dünner Schichten aus organischen Materialien. Typischerweise haben die Schichten eine Stärke im Bereich von 1nm bis 1μm. Das Ausbilden der Schichten erfolgt üblicherweise entweder im Vakuum mittels Aufdampfen oder aus einer Lösung, zum Beispiel mittels Aufschleudern oder Drucken.

Organische Leuchtdioden emittieren Licht nach Injektion von Ladungsträgern in Form von Elektronen von einer Seite und von sogenannten Löcher von der anderen Seite in dazwischen angeordnete organische Schichten. Die Ladungsträgerinjektion erfolgt auf Grund einer angelegten äußeren Spannung, der hierauf folgenden Bildung von Exzitonen, d.h. von Elektron-Loch-Paaren, in einer aktiven Zone und der strahlenden Rekombination dieser Exzitonen. Die Kontaktierung der organischen Schichten mit einer Anode (Löcher-injizierender Kontakt) und einer Kathode (Elektronen-injizierender Kontakt) erfolgt typischerweise mittels wenigstens einer transparenten Elektrode, in den weitaus meisten Fällen in Form eines transparenten Oxids, wie beispielsweise Indium-Zinn-Oxid (ITO), und eines metallischen Kontaktes.

Flachanzeigen auf Basis organischer Leuchtdioden (OLED) können sowohl als Passiv-Matrix als auch als Aktiv-Matrix realisiert werden. Bei Passiv-Matrix-Anzeigen wird das Bild erzeugt, indem zum Beispiel die Zeilen nacheinander selektiert werden und eine auf den Spalten gewählte Bildinformation dargestellt wird. Solche Anzeigen sind aus bautechnischen Gründen jedoch auf eine Größe von etwa 100 Zeilen beschränkt.

Für Anzeigen mit hohem Informationsgehalt ist eine aktive Ansteuerung der Bildelemente (Pixel) erforderlich. Hierzu wird jedes Bildelement von einer Schaltung mit Transistoren, einer Treiberschaltung, angesteuert. Die Transistoren werden zumeist als Dünnschichttransistoren (TFT - "Thin Film Transistor" - Dünnschichttransistor) ausgelegt.

Bekannt sind derartige Anzeigen bereits mit Flüssigkristallzellen als LC-TFT-Displays (LC - "Liquid Crystal" - Flüssigkristall). Hierbei werden die Reflexion oder der Durchlass einer externen Lichtquelle durch die LCDs gesteuert. Da die LCDs nicht selbst leuchten, sondern nur eine Lichtsteuerung bewirken, was in der Regel mittels einer spannungsabhängigen Polarisationsdrehung des Lichtes erreicht wird, werden die LCDs mit Hilfe der Treiberschaltung spannungsgesteuert, d.h. im wesentlichen leistungslos getrieben. Aus diesen Gründen genügt im allgemeinen eine Schaltung mit einem Transistor und einem Kondensator.

Anders verhält es sich bei Anzeigen mit organischen Leuchtdioden, welche mittels eines Stroms getrieben werden. Da hier eine Leistungssteuerung erfolgen muss, ist eine Schaltung mit mindestens zwei Transistoren, d.h. einem Ansteuertransistor und einem Treibertransistor, und einem Kondensator erforderlich. Der Transistor wird von einem eingehenden Datensignal geschaltet, um den Kondensator mit einer die beabsichtigte Helligkeit der OLED bestimmenden Ladung zu versehen. Der Kondensator bestimmt dann das Gatepotential des Treibertransistors, welcher letztendlich den Strom durch die organische Leuchtdiode.einstellt.

Aus dem Stand der Technik sind Vollfarb-Anzeigen bekannt, wie sie beispielsweise von der Firma Sanyo-Kodak hergestellt wurden. Hierbei werden für OLED-Anzeigen aktive Matrizen aus Poly-Silizium verwendet, die die jeweilige Treiberschaltung für die jeden Pixel enthalten. Die Transistoren in Matrizen aus polykristallinem Silizium sind in der Regel p-Kanal-Transistoren, die mit der Anode der OLED verbunden werden. Der Schichtaufbau der OLED beginnt mit der auf einem Glassubstrat angeordneten Anode und endet mit der Kathode; die OLED liegt lateral neben den Treibertransistoren und emittiert durch das Glassubstrat.

Der Vorteil der Matrizen aus polykristallinem Silizium liegt in der relativ hohen Beweglichkeit der Ladungsträger in diesem Material, die hohe Ströme für die Ansteuerung der OLED zulässt. Wie bereits J.L. Sanford and F.R. Liebsch im Jahr 2003 in *SID 03 Digest,* S. 10 ff zeigen, sind jedoch auf Grund der typischerweise relativ großen Inhomogenitäten des polykristallinen Siliziums aufwändige Ansteuerschaltungen mit vier oder mehr Transistoren erforderlich. Weitere Nachteile bei der Verwendung von Matrizen aus polykristallinem Silizium liegen in der aufwändigen Fertigung, da in der Regel ein Rekristallisationsschritt notwendig ist, in dem Aufwand der Fertigung auf größeren Substraten (welche für die kosteneffiziente Fertigung von Displays von großer Bedeutung ist) sowie in der relativ großen Inhomogenität der elektrischen Parameter.

Die Verwendung von Matrizen aus amorphem Silizium ("amorphous silicon"; a-Si) vermeidet die Nachteile der Matrizen aus polykristallinem Silizium: Matrizen aus amorphem Silizium sind zum einen wesentlich einfacher zu fertigen und zum anderen leichter auf größeren Substraten zu realisieren. Schließlich weisen Matrizen aus amorphem Silizium im Vergleich zu polykristallinem Silizium eine wesentlich bessere räumliche Homogenität der elektrischen Parameter auf. In der Regel sind aktive Matrizen auf Basis von amorphem Silizium mit n-Kanal-Transistoren realisiert. p-Kanal-Transistoren können prinzipiell auch verwendet werden, sind wegen der sehr geringen Löcherbeweglichkeit im undotierten Kanal aber nicht für die OLED-Ansteuerung geeignet.

Sowohl J.-J. Lih et al., *SID 03 Digest,* S. 14 ff, 2003 wie auch T. Tsujimura, *SID 03 Digest,* S. 6 ff, 2003 beschreiben erste OLED-Anzeigen mit Matrizen aus amorphem Silizium. Die bekannten Matrizen aus amorphem Silizium arbeiten mit n-Kanal-Transistoren. In beiden Fällen ist die Anode der organischen Leuchtdioden mit dem Ausgang einer TFT-Schaltung verbunden.

Obwohl die Verwendung von aktiven Matrizen aus amorphem Silizium die beschriebenen Vorteile hat, sind hiermit auch empfindliche Nachteile verbunden: Zum einen tritt aufgrund der generell wesentlich geringeren Beweglichkeiten des amorphen Siliziums eine Beschränkung der Ströme auf, was hoch effiziente OLED erfordert; zum anderen degradiert amorphes Silizium unter Belastung, so dass Einbrenn-Effekte und hierdurch Inhomogenitäten entstehen. Ein wesentlicher Effekt hierbei ist die Verschiebung der Schwellspannung $V_{th}$ der Transistoren wegen der Alterung.

Einfache typische Schaltungen für eine Anordnung für OLED-Anzeigen mit einer Matrix aus amorphem Silizium umfassen im allgemeinen zwei n-Kanal-Transistoren. Der erste Transistor, der sogenannte Ansteuertransistor, wird mittels einer Datensignalleitung und einer Zeilenanwahlleitung durchgeschaltet und lädt einen Kondensator, der den zweiten Transistor, der als Treibertransistor fungiert, steuert. Wird eine solche, sehr einfache und effizient zu realisierende 2-Transistor-Schaltung mit der Anode der OLED verbunden, so zeigt eine genauere Betrachtung, dass dies mit einem empfindlichen Nachteil verbunden ist: Soll der Treibertransistor im Sättigungsbereich betrieben werden, verlangt die Ansteuerung des Gates des Treibertransistors sehr hohe Schaltpotentiale ("voltage swings"). Diese können von Ansteuerschaltungen in üblicher CMOS-Silizium-Technologie nicht erzeugt werden. Zusätzlich beeinflussen bei dieser Beschaltung die Alterung der OLED und hiermit verbundene Spannungsveränderungen das Gatepotenzial des Treibertransistors. Da in jedem Falle die Spannung der OLED im Betrieb in die Steuerspannung des Treibertransistors eingeht, gestaltet sich diese Art Ansteuerung schwierig. Eine entsprechende Schaltung mit den genannten Nachteilen ist in J.-J. Lih et al., *SID 03 Digest,* S. 14, 2003 angegeben.

Der genannte Nachteil bei der Verwendung von zwei n-Kanal-Transistoren und der Verbindung des Treibertransistor mit der Anode kann mit Hilfe wesentlich aufwändigerer Schaltungen mit einer höheren Anzahl von Transistoren vermieden werden. Aus J.L. Sanford and F.R. Liebsch, *SID 03 Digest,* S. 10, 2003 ist ein Bildelement mit einer Schaltung und einer auf der Schaltung angeordneten Leuchteinheit offenbart, wobei als Treibertransistor ein n-Kanal-Transistor verwendet wird, die Anode der organischen Leuchtdiode mit dem Transistor verbunden ist und die Schaltung zur Kompensation von Inhomogenitäten vier bis sechs Transistoren aufweist. Die verschieden aufwendigen Schaltungen sollen mit mehr Transistoren Parameterschwankungen und Alterung der Leuchteinheit ausgleichen. Je mehr Transistoren in einem Bildelement verwendet werden, desto kostenintensiver wird jedoch deren Herstellung, da sich die Ausbeute entsprechend verringert. Weiterhin verringert sich die für den Treibertransistor zur Verfügung stehende Fläche, was die Problematik der Alterung verschärft.

Es wird noch darauf hingewiesen, dass die beschriebene Problematik in symmetrischer Weise gilt, wenn statt n-Kanal-Transistoren p-Kanal-Transistoren verwendet werden. In diesem Fall führt die direkte Verbindung des Treibertransistors mit der Kathode dazu, dass die OLED-Spannung im Betrieb mit in der Steuerspannung zu berücksichtigen ist.

Ein weiterer wichtiger Aspekt für die Realisierung von effizienten OLED-Anzeigen ist die Optimierung der Fläche der OLED. In den meisten OLED-Anzeigen emittiert die OLED durch das Glas-Substrat hindurch ("Bottom-Emitter"). In diesem Fall ist die für die Ansteuerung erforderliche Elektronik des Bildelements neben der OLED angeordnet. Folglich verbleibt für die tatsächliche Leuchteinheit des Bildelements, nämlich für die OLED, weniger als die Hälfte der Fläche des Bildelements. Je kleiner die Leuchteinheit im Vergleich zum Bildelement ausgebildet ist, mit umso höherer Stromdichte muss die OLED betrieben werden. Höhere Stromdichten wirken sich wiederum nachteilig auf die Lebensdauer aus.

Besser geeignet ist eine organische Leuchtdiode, die vom Substrat weg emittiert ("Top-Emitter"), da diese auf der Ansteuerschaltung aufgebaut werden kann und hierdurch die Bildelementfläche annähernd vollständig für die Leuchteinheit verwendet werden kann. T. Tsujimura et al., *SID 03,* S. 6, 2003 beschreiben eine solche Anordnung für Anzeigen mit einer Matrix aus amorphem Silizium. Hierbei kontaktiert die OLED-Anode den Treibertransistor. Die Lichtemission erfolgt durch die transparente Kathode. Diese Anordnung hat den bereits erwähnten Nachteil, dass die OLED-Spannung in die Steuerspannung eingeht und der Vorteil des Sättigungsbetriebs des Treibertransistors nicht genutzt werden kann. Deshalb reagiert der OLED-Ansteuerstrom, erzeugt durch den Treibertransistor, empfindlich auf Verschiebungen der Schwellspannung ($V_{th}$) und auf Änderungen der organischen Leuchtdiode. Solche Verschiebungen sind bei Alterung der Transistoren und OLED unvermeidlich.

Die Erfindung

Aufgabe der Erfindung ist es, ein Bildelement für eine Aktiv-Matrix-Anzeige mit einer organischen Leuchtdiode zu schaffen, welches eine effiziente Ausnutzung der Fläche ermöglicht. Des weiteren soll die Herstellung des Bildelements mit Hilfe der Nutzung kostengünstiger Verfahren ermöglicht sein.

Erfindungsgemäß wird diese Aufgabe für ein Bildelement nach dem Oberbegriff des Anspruchs 1 dadurch gelöst, dass eine mittels einer Dotierung leitfähig ausgebildete Transportschicht der Leuchtdiode mit dem Drain-Kontakt des Treibertransistors elektrisch verbunden ist.

In Verbindung mit einer geeigneten Auslegung der Treiberschaltung wird auf diese Weise erreicht, dass der Treibertransistor in Sättigung betrieben werden kann und deshalb relativ unempfindlich gegenüber Alterungsvorgängen ist.

Die Verbindung der Treiberschaltung mit der organischen Leuchtdiode erfolgt über die dotierte Transportschicht. So wird vermieden, dass aufgrund einer Verbindung eines Kontaktmetalls mit einer undotierten organischen Schicht ein hochohmiger Kontakt entsteht. Die vorgeschlagene dotierte Transportschicht ermöglicht es, die Leuchtdiode an darunter liegende schichten im Bildelement anzupassen, wodurch der Herstellungsprozess mittels Wahl geeigneter Dotiermaterialen und der hierdurch möglichen Anpassung kostengünstig gestaltet werden kann, was den Einsatz sowohl von n-Kanal-Treibertransistoren (in Verbindung mit einem Anschluß an eine Kathode der Leuchtdiode) als auch von p-Kanal-Treibertransistoren (in Verbindung mit dem Anschluß an eine Anode der Leuchtdiode) ermöglicht.

Mit Hilfe der Dotierung wird die Leitfähigkeit der leitenden Transportschicht der organischen Leuchtdiode im Bereich der üblichen Betriebstemperaturen um Größenordnungen erhöht.

Aufgrund der Verbindung der dotierten Transportschicht mit dem Drain-Kontakt des Treibertransistors wird weiterhin vermieden, dass die Gate-Source-Spannung des Treibertransistors von der Spannung über der organischen Leuchtdiode beeinflusst wird. Hierdurch werden Streuungen von Parametern der Leuchtdioden oder Alterungserscheinungen, die zu einer Veränderung der Spannung über der der Leuchtdiode führen, einen negativen Einfluss auf die Sättigung des Treibertransistors ausüben, so dass dadurch der Stromfluss durch die Leuchtdiode und letzten Endes deren Helligkeit stabil gehalten wird.

Vorteilhafte Ausgestaltungen der Erfindung sind Gegenstand abhängiger Unteransprüche.

Beispielsweise kann ein verwendeter n-Dotand ein molekularer Dotand mit einer Molekülmasse größer als etwa 200 g/mol sein. Ein bevorzugtes Beispiel ist der n-Dotand Pyronin D oder Leukokristallviolett (A. Werner et al., Appl. Phys. Lett. 82, 4495 (2003)). In einem alternativen Beispiel ist eine n-dotierte Transportschicht Lithium-dotiertes 4,7-Diphenyl-1,10-phenanthrolin. Das molekulare Mischungsverhältnis liegt für 4,7-Diphenyl-1,10-phenanthrolin (Bphen) : Lithium (Li) zwischen etwa 10 : 1 und etwa 1 : 1, bevorzugt zwischen etwa 5 : 1 und etwa 1 : 1, und besonders bevorzugt bei etwa 1 : 1. Andere n-Dotierungsvarianten können ebenfalls genutzt werden. Die Elektronentransportschicht weist eine Dicke im Bereich von etwa 20 nm bis etwa 100 nm, vorzugsweise etwa 40 nm auf.

Eine p-dotierte Transportschicht (Löchertransportschicht) ist bevorzugt aus Starburst 4,4,4-Tris(3-methylphenylphenylamino)triphenylamin (m-MTDATA) und mit einem bis etwa 80 °C thermisch stabilen 2,3,5,6-Tetrafluoro-7,7,8,8-tetracyano-$p$-chinodimethan-($F_4$-TCNQ)-Dotanden oder einem 1,6-Diaminopyren-(DAP)-$F_4$-TCNQ-Dotanden p-dotiert. Andere p-Dotierungsvarianten sind nutzbar. Das Mischungsverhältnis liegt zwischen etwa 1000 : 1 und etwa 10 : 1, bevorzugt zwischen etwa 100 : 1 und etwa 20 : 1. Die Löchertransportschicht weist eine Dicke im Bereich von etwa 30 nm bis etwa 300 nm, vorzugsweise etwa 100 nm auf.

In einer Ausgestaltung der Erfindung ist vorgesehen, dass die dotierte Transportschicht über eine flächige Elektrode mit dem Drain-Kontakt des Treibertransistors verbunden ist. Die Elektrode dient der Kontaktierung mit dem Drain-Kontakt, was mit herkömmlichen Mitteln der Metallisierung erreicht werden kann.

Bei einer Fortbildung der Erfindung ist vorgesehen, dass die leitfähige Transportschicht direkt mit dem Drain-Kontakt des Treibertransistors verbunden ist. Dies ist aufgrund der Anpassbarkeit der Transportschicht mittels Dotierung ermöglicht und stellt wegen des Wegfalls einer Metallisierung eine Vereinfachung des Herstellungsprozesses dar.

In einer anderen Ausgestaltung der Erfindung ist vorgesehen, dass die Kontaktierung des Drain-Kontakts des Treibertransistors mit einer Kompositschicht aus mindestens einem organischen Material, das ggf. dotiert ist, und einer metallischen Komponente erfolgt. Eine solche Kompositschicht hat hohe elektrische Leitfähigkeit und kann zum Beispiel mittels Ko-Verdampfung hergestellt werden.

Bei einer Ausführungsform der Erfindung wird die mit dem Treibertransistor verbundene Elektrode (Anode/Kathode) so ausgelegt, dass sie die von den aktiven Schichten der OLED emittierte Strahlung möglichst effizient reflektiert. Dies kann beispielsweise mittels eines hoch reflektierenden Materials wie Silber erreicht werden. In diesem Zusammenhang entfaltet die Erfindung besondere Vorteile, da hoch reflektierende Metalle oft eine grosse Austrittsarbeit haben und deswegen insbesondere mit elektronenleitenden organischen Schichten keinen guten Kontakt ergeben.

In einer weiteren Ausgestaltung der Erfindung wird die mit dem Treibertransistor verbundene Elektrode so ausgelegt, dass sie die von den aktiven Schichten der OLED emittierte Strahlung aufgrund einer Mehrschichtanordnung effizient reflektiert. Dies kann beispielsweise mittels einer dielektrischen Mehrfachschicht erreicht werden. Dies kann besonders effizient mit der Erfindung verbunden werden, da zum Beispiel eine Durchkontaktierung durch die Reflexionsschichten mit Hilfe der dotierten organischen Schichten möglich ist.

In einer Weiterbildung der Erfindung wird die mit dem Treibertransistor verbundene Elektrode so ausgelegt, dass sie die von den aktiven Schichten der OLED emittierte Strahlung durch eine Mehrschichtanordnung effizient reflektiert. Dies kann beispielsweise mit Hilfe einer dielektrischen Mehrfachschicht erreicht werden. Dies ist in Verbindung mit der Erfindung besonders effizient, da zum Beispiel eine Durchkontaktierung durch die Reflexionsschichten mit Hilfe der dotierten organischen Schichten möglich ist.

In einer bevorzugten Ausführungsform der Erfindung wird die mit dem Treibertransistor verbundene Elektrode so ausgelegt, dass sie die einfallendes Licht möglichst wenig reflektiert (reflexionsvermindernd). Dies kann beispielsweise mittels geeigneter dielektrischer Schichten oder organisch-metallischer Kompositschichten erreicht werden. Obwohl die Effizienz der organischen Leuchtdiode hierdurch in der Regel gesenkt wird, wird erreicht, dass von außen einfallendes Licht nicht reflektiert wird und hierdurch der Kontrast der OLED-Anzeige hoch wird, ohne dass weitere Maßnahmen wie zum Beispiel Polarisationsfilter zur Steigerung des Kontrastes verwendet werden.

Die hier vorgeschlagene Anordnung kann auch auf Treiberschaltungen mit mehr als zwei Transistoren verallgemeinert werden kann. Eine hinsichtlich der Stabilität sehr sichere Ausgestaltung der Erfindung sieht vor, dass die Treiberschaltung vier Transistoren in einer Stromspiegel-Anordnung aufweist, wobei der Treibertransistor als Teil der Stromspiegel-Anordnung gebildet ist. Mittels der Stromspiegel-Anordnung wird in dem Treibertransistor ein Spiegelstrom eingestellt, der zusätzlich zu den oben genannten Maßnahmen äußerst unabhängig ist von der Exemplarstreuung der Bauelemente des Bildelements, insbesondere von Exemplarstreuungen und Alterungserscheinungen der Leuchtdiode.

Die Stromspiegel-Anordnung wird gebildet von vier Transistoren und einem Kondensator. Die Schaltungsanordnung und der Transistortyp sind grundsätzlich bekannt, beispielsweise in J. L. Sanford, F. R. Libsch, SID 2003, S. 10 ff beschrieben. Alternativ ist auch jede andere Stromspiegelschaltung verwendbar. Mittels der Stromspiegelanordnung wird erreicht, dass der Treibertransistor auch bei Verschiebungen der Schwellspannung aufgrund von Alterung des Transistors und/oder der organischen Leuchtdiode ganz sicher im Sättigungsbereich betrieben wird, so dass die Alterung nicht oder allenfalls nur in geringem Umfang zu einer Helligkeitsveränderungen der Leuchtdiode und somit der Lichtemission des Bildelements führt.

Die Erfindung kann auch dadurch vorteilhaft weitergebildet werden, dass die Leuchtdiode als eine transparente organische Leuchtdiode ausgebildet ist. Eine voll transparente (> 70 % Transmission) organische Leuchtdiode weist eine hohe Lichteffizienz auf. Gleichzeitig ist der Schutz aller organischen Schichten, insbesondere aber der lichtemittierenden Schichten, vor Beschädigungen des transparenten Deckkontaktes gewährleistet. Bei einer derartigen transparenten OLED ist die Löchertransportschicht mit einem organischen Akzeptormaterial p-dotiert und die Elektronentransportschicht mit einem Donormaterial n-dotiert mit Dotanden mit einer Masse > 200 g/mol. Beispielsweise können die in der Patenanmeldung DE 102 15 210 beschriebenen transparenten OLEDs verwendet werden.

Schließlich ist es besonders zweckmäßig, dass die Treiberschaltung und die Leuchtdiode auf einem gemeinsamen Substrat aufgebracht sind, derart, dass dass die Treiberschaltung und die Leuchtdiode auf einem gemeinsamen Substrat (gebildet sind, wobei die Treiberschaltung zwischen der Leuchtdiode und dem gemeinsamen Substrat angeordnet ist und wobei die Leuchtdiode als Top-Emitter-OLED mit einer vom gemeinsamen Substrat weg gerichteten Leuchtrichtung gebildet ist.

Unterhalb der organischen Leuchtdiode liegt somit die Ansteuerschaltung. Hierdurch kann die Fläche des Bildelements maximiert und somit ohne eine Erhöhung des Stromflusses die Leuchtkraft gesteigert werden. Ein derart gestaltetes Bildelement weist einen Schichtaufbau mit einer Substratbasis, der darauf angeordneten Treiberschaltung und der hierauf gebildeten organischen Leuchtdiode auf. OLED, die vom Substrat weg emittieren ("Top-Emitter"), werden auf der Ansteuerschaltung aufgebaut, so dass die Bildelementfläche annähernd vollständig für die Leuchteinheit verwendet werden kann. Die Lichtemission erfolgt durch die oben liegende transparente Elektrode hindurch. Fertigungstechnisch vorteilhaft ist ein derartiger Schichtaufbau insofern, als das Aufbringen der Treiberschaltung auf das Substrat unter drastischeren Bedingungen, wie beispielsweise bei höherer Temperatur, erfolgt als die Aufbringung der organischen Leuchtdiode. Die Leuchtdiode wird somit keinen weiteren Belastungen weiterer Fertigungsprozesse ausgesetzt, mit Ausnahme der beim eigenen Aufbringen. Als Top-Emitter erstreckt sich die Leuchtdiode im wesentlichen über die gesamte Grundfläche des Bildelements. Diese Ausführungsform ist in Verbindung mit einer in Sättigung betriebenen 2-Transistor-Schaltung in besonders vorteilhafter Weise möglich.

<u>Zeichnung</u>

Die Erfindung wird nachfolgend anhand von Ausführungsbeispielen unter Bezugnahme auf eine Zeichnung näher erläutert. Hierbei zeigen:

Fig. 1    eine Schaltungsanordnung eines Bildelements nach einem ersten Ausführungsbeispiel;

Fig. 2    einen Querschnitt durch ein Bildelement nach dem ersten Ausführungsbeispiel in Fig. 1 mit einem obenliegenden Gate;

Fig. 3    einen Querschnitt durch ein Bildelement nach einem zweiten Ausführungsbeispiel mit einem untenliegenden Gate;

Fig. 4    eine Schaltungsanordnung für ein Bildelement mit einer Stromspiegelanordnung;

Fig. 5    eine Schaltungsanordnung für ein mit einer Stromspiegel-Anordnung und nur einer Scanleitung;

Fig. 6    eine Schaltungsanordnung für ein Bildelement mit zwei p-Kanal-TFTs;

Fig. 7    einen Querschnitt durch ein Bildelement, bei dem eine p-dotierte Transportschicht mit dem Drain-Kontakt eines p-Kanal-Treibertransistors verbunden ist; und

Fig. 8    eine Schaltungsanordnung mit drei n-Kanal-TFTs, welche zur besseren Homogenität des auf einer Anzeige dargestellten Bildes eine Schwellspannungskorrektur des Treibertransistors enthält.

Ausführungsbeispiele

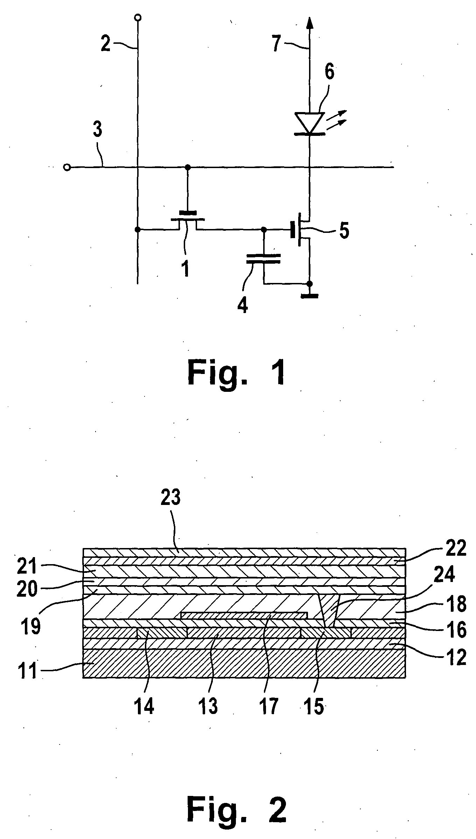

Die Erfindung wird im folgenden unter Bezugnahme auf Fig. 1 zunächst anhand eines in der Praxis besonders relevanten Ausführungsbeispiels eines Bildelements für eine Aktiv-Matrix-Anzeige mit einer Schaltung mit n-Kanal-Transistoren, wie sie vorzugsweise auf Basis amorphen Siliziums realisierbar sind, erläutert.

Fig. 1 zeigt ein vereinfachtes elektrisches Schaltbild einer Schaltungsanordnung eines Bildelements nach einem ersten Ausführungsbeispiel, wobei die Schaltung zwei Transistoren umfasst. Ein erster Transistor, bezeichnet als Ansteuertransistor 1, dient der Speicherung des Potentials einer Datensignalleitung 2, in der mittels einer Zeilenanwahlleitung 3 durchgeschaltet wird und ein Kondensator 4 mit dem Potential der Datensignalleitung 2 geladen wird. Der Kondensator 4 steuert einen zweiten Transistor, den Treibertransistor 5. Die Kathode einer organischen Leuchtdiode (OLED) 6 ist mit dem Drain-Kontakt des Treibertransistors 5 verbunden und erhält den Betriebsstrom aus einer Versorgungsleitung 7, die mit einer Betriebsspannung Vdd beaufschlagt ist.

Mit Hilfe der Schaltungsanordnung nach Fig. 1, bei der eine direkte Verbindung zwischen Kathode der OLED und dem Drain-Kontakt des Treibertransistors 5 gebildet ist, wird erreicht, dass der Treibertransistor 5 im Sättigungsbereich betrieben wird, so dass mögliche Verschiebungen der Schwellspannung aufgrund einer Alterung des Treibertransistors 5 oder der OLED 6 nicht oder allenfalls nur in geringem Umfang zu Helligkeitsveränderungen bei dem Bildelement führen. Die Kathode der OLED 6 ist mit dem Drain-Kontakt des Treibertransistors 5 verbunden und erhält den Betriebsstrom aus der Versorgungsleitung 7. Eine derartige Anordnung bewirkt, dass der Treibertransistor 5 im Sättigungsbereich betrieben werden kann, ohne dass der "Voltage Swing" einer externen Ansteuerschaltung zu groß wird. Dies kann anhand der folgenden Berechnung gezeigt werden:

Sättigungsbedingung:

$$V_{tT2} < V_{GS2} < V_{tT2} + V_{DS2}$$

$$V_{DATA} = V_{DS1} + V_{GS2} \approx V_{GS2} \qquad (V_{DS1} \approx 0)$$

$$V_{DD} = V_{DS2} + V_F$$

$$V_{tT2} < V_{DATA} < V_{tT2} + V_{DS2}.$$

$$I_{OLED} = 0.5\ k \cdot (V_{DATA} - V_{tT2})^2$$

Eine Verschiebung der Schwellspannung aufgrund von Alterung des Treibertransistors 5 kann aufgrund der obigen Überlegungen nicht oder nur in geringem Umfang zu Helligkeitsveränderungen führen.

Umgekehrt würde eine Kontaktierung des Drain-KOntaktes des Treibertransistors 5 mit der Anode der OLED zu exzessiven "Voltage Swings" führen, die unter bestimmten Bedingungen die Anzeige-Versorgungsspannung übersteigen können:

Sättigungsbedingung:

$$V_{tT2} < V_{GS2} < V_{tT2} + V_{DS2}$$

$$V_{DATA} = V_{DS1} + V_F + V_{GS2} \approx V_F + V_{GS2} \qquad (V_{DS1} \approx 0)$$

$$V_{DD} = V_{DS2} + V_F$$

$$V_{tT2} + V_F < V_{GS2} + V_F < V_{tT2} + V_{DS2} + V_F$$

$$V_{tT2} + V_F < V_{DATA} < V_{tT2} + V_{DD}$$

$$I_{OLED} = 0.5 \, k \cdot (V_{DATA} - V_{tT2} - V_F(I_{OLED}))^2$$

Fig. 2 zeigt einen Querschnitt eines Bildelements nach dem ersten Ausführungsbeispiel in Fig. 1 mit einem oben liegenden Gate ("top gate"). Der dargestellte Aufbau umfasst eine mögliche technologische Auslegung der in Fig. 1 skizzierten Schaltung mit einer von einem Substrat weg emittierenden organischen Leuchtdiode ("Top-Emitter").
Auf einem Träger (Substrat) 11 aus Glas ist eine Schaltung aus amorphem Silizium aufgebracht. Auf der Schaltung ist eine organische Leuchtdiode angeordnet. Auf dem Träger 11 ist zusätzlich eine Isolationsschicht 12 aus $SiN_x$ aufgebracht. Hierauf angeordnet ist eine dünne Schicht aus intrinsischem, amorphem Silizium als Kanal 13 des Transistors, der beim Durchschalten n-leitend wird. Ein Source-Kontakt 14 liegt auf einer Seite und ein Drain-Kontakt 15 auf einer gegenüberliegenden Seite des Kanals 13. Die Source-/Drain-Kontakte 14, 15 sind dünne Schichten aus n-dotiertem Silizium, die den dazwischenliegenden Kanal 13 jeweils kontaktieren.
Auf einer weiteren aufgebrachten Schicht aus $SiN_x$ eines Gate-Isolators 16 ist ein Gate-Kontakt 17 als "top gate" aufgebracht. Das Gate 17 ist eine Schicht aus einer Titan-Platin-Legierung (TiPt). Überzogen wird die Gate-Einheit mit dem Gate 17 von einer Passivierungsschicht 18.
Hierauf ist dann eine organische Leuchtdiode (OLED) mit einer oder mehreren organischen Schichten aufgebracht. Auf der Passivierungsschicht 18 ist eine Kathode 19 aus Aluminium angeordnet, auf die eine dotierte Elektronentransportschicht 20 aufgetragen ist. Die Elektronentransportschicht 20 ist n-dotiert. Sie hat vorzugsweise eine Dicke von etwa 40 nm und ist aus einem Lithium-dotierten 4,7-Diphenyl-1,10-phenanthrolin mit 4,7-Diphenyl-1,10-phenanthrolin (Bphen) : Lithium (Li) im molekularen Mischungsverhältnis von etwa 1 : 1. Andere Dotierungsvarianten sind ebenfalls möglich.
Auf der Elektronentransportschicht 20 ist ein Emitterschichtaufbau 21 der organischen Leuchtdiode aus mehreren Schichten angeordnet. Der Emitterschichtaufbau 21 umfasst eine elektronenseitige Blockschicht aus Bphen mit einer Dicke von etwa 10 nm, darüber eine etwa 20 nm dicke elektolumineszierende Schicht aus tris-(8-Hydroxychinolin)- aluminium ($Alq_3$), welche zur Erhöhung der internen Quantenausbeute der Lichterzeugung mit Emitterdotanden - unter anderem mit Chinacridonen - vermischt ist, und weiter eine löcherseitige Blockschicht aus N,N-Diphenyl-N,N-bis(3-methylphenyl)-(1,1-biphenyl)-4,4-diamin (TPD) mit einer Dicke von etwa 5 nm.
Eine etwa 100 nm dicke Löchertransportschicht 22 liegt auf dem Emitterschichtaufbau 21, wobei die Löchertransportschicht 22 bei diesem Ausführungsbeispiel p-dotiert ist. Die Löchertransportschicht 22 ist aus Starburst 4,4,4-Tris(3-methylphenylphenylamino)triphenyl-amin (m-MTDATA), die mit einem bis etwa 80 °C thermisch stabilen 2,3,5,6-Tetrafluoro-7,7,8,8-tetracyano-$p$-chinodimethan-($F_4$-TCNQ)-Dotanden oder einem 1,6-Diaminopyren-(DAP)-$F_4$-TCNQ-Dotanden p-dotiert ist.
Oberseitig abschließend ist eine semitransparente Anode 23 aus Indium-zinn-Oxid (ITO) aufgebaut, so dass das emittierte Licht durch diese hindurch aus dem organischen Schichtaufbau austreten kann. Die Anode 23 wird vor seitlichem Kontakt mit der Kathode 19 der organischen Leuchtdiode mittels einer weiteren Auftragung geschützt, nämlich Isolationsschichten (nicht dargestellt).
Bei der Herstellung werden die organischen Schichten im Rahmen eines Aufdampfprozesses im Vakuum mittels Mischverdampfung (im Falle von dotierten Schichten) aufgebracht. Grundsätzlich können die Schichten aber auch mit Hilfe anderer aus dem Stand der Technik bekannter Verfahren aufgebracht werden, wie zum Beispiel Aufeinanderdampfen der Substanzen mit anschließender, wahlweise temperaturgesteuerter Diffusion der Substanzen ineinander oder Aufschleudern der bereits gemischten Substanzen, was im Vakuum ausgeführt werden kann. Insbesondere die beiden Blockschichten, die elektronenseitige Blockschicht und die löcherseitge Blockschicht, werden im Vakuum aufgedampft, können alternativ auch mittels Aufschleudern aufgebracht werden.

Die Treiberschaltung des Bildelements ist mit dem Drain-Kontakt 15 über eine Durchkontaktierung 24 direkt mit der Kathode 19 der organischen Leuchtdiode verbunden. Hierbei tritt die Durchkontaktierung 24 an einer Stelle durch die Passivierungsschicht 18 und durch den Gate-Isolator 16 hindurch.

Vorteil dieser Anordnung ist es, dass aufgrund der direkten Kontaktierung zwischen der Kathode 19 und dem n-Kanal 13 über die Durchkontaktierung 24 und den Drain-Kontakt 15 der Treibertransistor in Sättigung betrieben werden kann und deshalb gegen Verschiebung der Schwellspannung unempfindlich ist. Weiterhin gestattet die direkte Kontaktierung zwischen dem Ausgang des Transistors und der Kathode 19 einen sehr einfachen technischen Aufbau.

Voraussetzung für die Realisierung ist die Ausbildung der organischen Leuchtdiode als eine vom Substrat weg emittierende Leuchtdiode. Hierbei besteht das grundlegende Problem, dass eine solche OLED in der Regel deutlich weniger effizient ist als eine organische Leuchtdiode, die durch das Substrat hindurch emittiert. Dieses Problem wird mittels Dotierung der Transportschichten gelöst, wie dies insbesondere in der Patentanmeldung DE 101 35 513 beschrieben ist. Alternativ können auch voll transparente organische Leuchtdioden verwendet werden, wie sie insbesondere in der Patenanmeldung DE 102 15 210 offenbart sind.

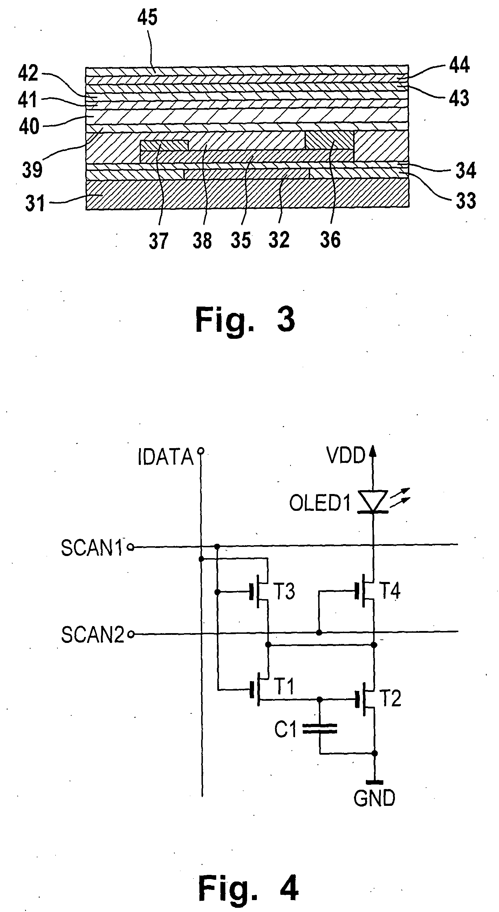

Fig. 3 zeigt einen Querschnitt eines Bildelements nach einem zweiten Ausführungsbeispiel mit einem untenliegenden Gate.

Direkt auf einem Träger (Substrat) 31 ist ein Gate-Kontakt 32 als "bottom gate" aufgebracht. Der Träger 31 ist typischerweise aus Glas. Der Gate-Kontakt 32 ist aus einer Titan-Platin-Legierung (TiPt). Darüber liegt eine Isolationsschicht 33 aus $SiN_x$, gefolgt von einer Gate-Isolation 34, die als eine Schicht aus $SiN_x$ gebildet ist.

Hierauf angeordnet ist eine dünne Schicht aus intrinsischem, amorphem Silizium als Kanal 35 des Transistors, der beim Durchschalten n-leitend wird. Ein Drain-Kontakt 36 liegt auf einer Seite und ein Source-Kontakt 37 auf einer gegenüberliegenden Seite des Kanals 35. Die Source-/Drain-Kontakte 36, 37 sind dünne Schichten aus Aluminium, die den dazwischenliegenden Kanal 35 jeweils kontaktieren. An die Source-/Drain-Kontakte 36, 37 angrenzenden Source-/Drain-Gebiete sind aus n-dotiertem Silizium.

Oberhalb ist über einer Isolationsschicht 38, die wiederum aus $SiN_x$ ist, eine organische Leuchtdiode (OLED) mit einer oder mehreren organischen Schichten aufgebracht. Die unterste Schicht der OLED ist eine Kathode 39 aus Aluminium, auf die eine dotierte Elektronentransportschicht 40 aufgetragen ist. Die Elektronentransportschicht 40 ist n-dotiert. Sie hat eine Dicke von etwa 40 nm und ist aus Lithium-dotiertes 4,7-Diphenyl-1,10-phenanthrolin mit 4,7-Diphenyl-1,10-phenanthrolin (Bphen) : Lithium (Li) im molekularen Mischungsverhältnis von etwa 1 : 1.

Auf der Elektronentransportschicht 40 ist ein Emitterschichtaufbau aus mehreren Schichten angeordnet. Der Emitterschichtaufbau umfasst eine elektronenseitige Blockschicht 41 aus Bphen mit einer Dicke von etwa 10 nm, darüber eine etwa 20 nm dicke elektrolumineszierende Schicht 42 aus tris-(8-Hydroxychinolin)- aluminium ($Alq_3$), welche zur Erhöhung der internen Quantenausbeute der Lichterzeugung mit Emitterdotanden vermischt ist, und weiter eine löcherseitige Blockschicht 43 aus N,N-Diphenyl-N,N-bis(3-methylphenyl)-(1,1-biphenyl)-4,4-diamin (TPD) mit einer Dicke von etwa 5 nm.

Eine etwa 100 nm dicke Löchertransportschicht 44 liegt auf dem Emitterschichtaufbau, wobei die Löchertransportschicht 44 bei diesem Ausführungsbeispiel p-dotiert ist. Die Löchertransportschicht 44 ist aus Starburst 4,4,4-Tris(3-methylphenylphenylamino)triphenyl-amin (m-MTDATA), die mit einem bis etwa 80 °C thermisch stabilen 2,3,5,6-Tetrafluoro-7,7,8,8-tetracyano-p-chinodimethan-($F_4$-TCNQ)-Dotanden oder einem 1,6-Diaminopyren-(DAP)-$F_4$-TCNQ-Dotanden p-dotiert ist.

Oberseitig abschließend ist eine semitransparente Anode 45 aus Indium-Zinn-Oxid (ITO) aufgebracht, so dass das emittierte Licht durch diese hindurch aus dem organischen Schichtaufbau der OLED austreten kann.

Fig. 4 zeigt ein vereinfachtes elektrisches Schaltbild einer Treiberschaltung für ein Bildelement. Die Treiberschaltung umfast eine Stromspiegel-Anordnung mit vier n-Kanal-Transistoren T1, T2, T3, T4 und einem Kondensator C. Die Transistoren T1 und T3 werden mittels der Zeilenleitung SCAN 1 durchgeschalten. Zusammen mit dem T1 wird über den Transistor T3 von der Datenleitung ("data line") der Kondensator C geladen. Nach dessen Aufladung fließt der Strom von der Datenleitung durch T2. Mit SCAN 2 wird der Transistor T4 durchgeschaltet, während SCAN 1 abgeschaltet ist. Gesteuert von der Spannung über der Kapazität (Kondensator C) stellt dann der Transistor T2 denselben (Spiegel-) Strom durch die OLED ein.

Mittels dieser Art der Anordnung einer Treiberschaltung mit Stromspiegel wird ebenfalls erreicht, dass der Treibertransistor - nämlich der Transistor, der mit seinem Gate-Kontakt an den Kondensator geschaltet ist - im Sättigungsbereich betrieben wird, so dass mögliche Verschiebungen der Schwellspannung aufgrund von Alterung des Treibertransistors und/oder der Leuchtdiode nicht oder allenfalls nur in geringem Umfang zu Helligkeitsveränderungen führen. In diesem Falle ist der Treibertransistor T2 mittelbar mit dem positiven Pol $V_{DD}$ der Betriebsspannungsquelle, d.h. der Versorgungsleitung verbunden und somit mittelbar zwischen die Pole der Betriebsspannungsquelle geschaltet, indem der Transistor T4 zwischen dem positiven Pol $V_{DD}$ und dem Treibertransistor T2 liegt. Dennoch bleibt die OLED (OLED1 in Fig. 3) mit dem stromführenden Pfad des Treibertransistors T2 in Reihe geschaltet.

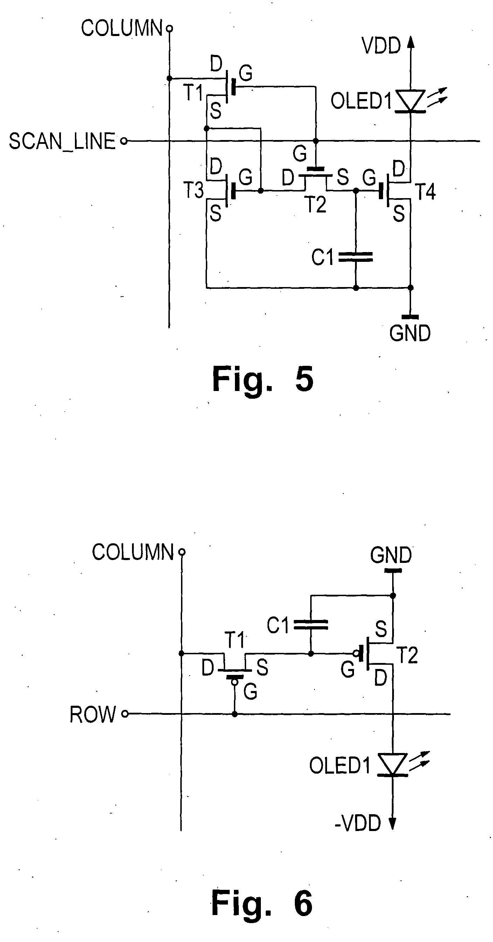

Fig. 5 zeigt eine andere Ausführung einer Stromspiegel-Anordnung, welche nur eine SCAN-Leitung verwendet. Voraussetzung ist hierbei eine genaue Kenntnis der Parameter der Transistoren T3 und T4, da in diesem Fall der einzustellende Strom nicht durch den Treibertransistor T2 der OLED fließt, sondern über das Verhältnis der beiden Transistoren gebildet wird.

Fig. 6 zeigt eine Schaltungsausführung einer 2-TFT-Schaltung mit p-Kanal-Transistoren, wobei eine p-dotierte Transportschicht der Anode der OLED mit dem Drain-Kontakt des Treibertransistors verbunden ist.

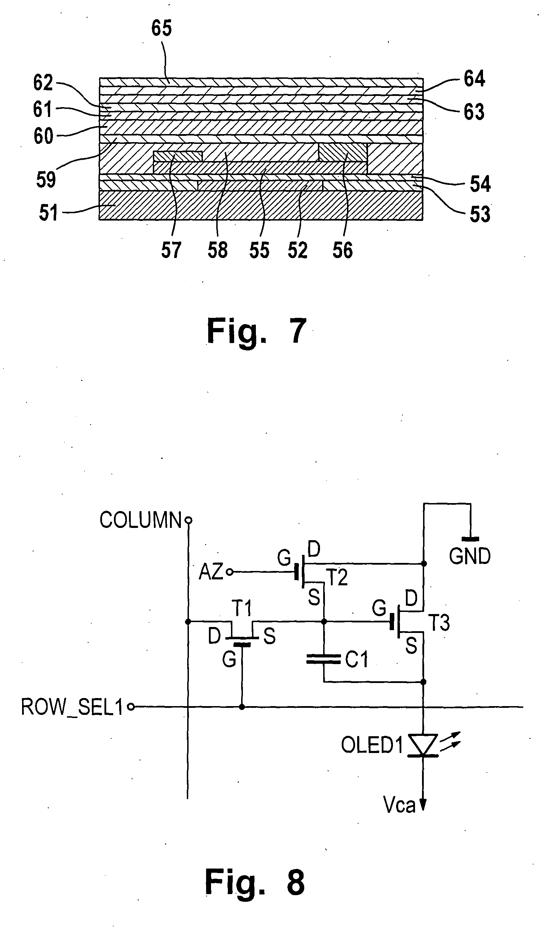

Fig. 7 zeigt einen Querschnitt eines Bildelements mit einem p-Kanal-Transistor mit einem unten liegenden Gate-Kontakt und einer OLED, bei der die Anode mit dem Treibertransistor verbunden ist.

Direkt auf dem Träger (Substrat) 51 ist ein Gate-Kontakt 52 als "bottom gate" aufgebracht. Der Träger 51 ist typischerweise aus Glas, das Gate 2 aus einer Titan-Platin-Legierung (TiPt). Hierüber liegt eine Isolationsschicht 53 aus $SiN_x$, gefolgt von einer Gate-Isolation 54, die als eine Schicht aus $SiN_x$ gebildet ist.

Hierauf angeordnet ist eine dünne Schicht aus intrinsischem Silizium als Kanal 55 des Transistors, der beim Durchschalten p-leitend wird. Ein Drain-Kontakt 56 liegt auf der einen und ein Source-Kontakt 57 auf einer gegenüberliegenden Seite des Kanals 55. Die Source-/Drain-Kontakte 56, 57 sind dünne Schichten aus Aluminium, die den dazwischenliegenden Kanal 55 jeweils kontaktieren. An die Source-/Drain-Kontakte 56, 57 angrenzenden Source-/Drain-Gebiete sind aus p-dotiertem Silizium.

Oberhalb ist über einer Isolationsschicht 58, die wiederum aus $SiN_x$ ist, eine organische Leuchtdiode (OLED) mit einer oder mehreren organischen Schichten aufgebracht. Unterste Schicht der OLED ist eine Anode 59 aus Aluminium, auf die eine dotierte Löchertransportschicht 60 aufgetragen ist. Die Löchertransportschicht 60 ist p-dotiert. Sie hat eine Dicke von etwa 100 nm und ist aus Starburst 4,4,4-Tris(3-methylphenylphenylamino)triphenyl-amin (m-MTDATA), die mit einem bis etwa 80 °C thermisch stabilen 2,3,5,6-Tetrafluoro-7,7,8,8-tetracyano-$p$-chinodimethan-($F_4$-TCNQ)-Dotanden oder einem 1,6-Diaminopyren-(DAP)-$F_4$-TCNQ-Dotanden p-dotiert ist.

Auf der Löchertransportsschicht 60 ist ein Emitterschichtaufbau aus mehreren Schichten angeordnet. Der Emitterschichtaufbau umfasst eine löcherseitige Blockschicht 61 aus N,N-Diphenyl-N,N-bis(3-methylphenyl)-(1,1-biphenyl)-4,4-diamin (TPD) mit einer Dicke von etwa 5 nm. Hierauf folgt eine etwa 20 nm dicke elektrolumineszierende Schicht 62 aus tris-(8-Hydroxychinolin)- aluminium ($Alq_3$), welche zur Erhöhung der internen Quantenausbeute der Lichterzeugung mit Emitterdotanden vermischt ist. Hierauf ist dann eine elektronenseitige Blockschicht 63 aus Bphen mit einer Dicke von etwa 10 nm angeordnet.

Eine etwa 40 nm dicke Elektronentransportschicht 64 liegt auf dem Emitterschichtaufbau, wobei die Elektronentransportschicht 64 bei diesem Ausführungsbeispiel n-dotiert ist. Die Elektronentransportschicht 64 ist aus einem Lithium-dotierten 4,7-Diphenyl-1,10-phenanthrolin mit 4,7-Diphenyl-1,10-phenanthrolin (Bphen) : Lithium (Li) im molekularen Mischungsverhältnis von etwa 1 : 1.

Oberseitig abschließend ist eine semitransparente Kathode 65 aus Indium-Zinn-Oxid (ITO) aufgebracht, so dass das emittierte Licht durch diese hindurch aus dem organischen Schichtaufbau der OLED austreten kann.

Fig. 8 zeigt eine Schaltungsanordnung., bei der eine Schwellspannungskompensation des Treibertransistors ausgeführt wird. Um ein neues Bild auf der Anzeige darzustellen, muß ein gemeinsames Kathodenanschluss der OLED Vca für eine kurze Zeit auf ein hohes positives Potential, bezogen auf GND, gebracht werden, um die OLEDs in Rückwärtsrichtung angesteuert, komplett zu entladen. Hierauf folgend werden ein Gate-Anschluss eines Transistors T2, in Fig. 8 bezeichnet mit AZ, auf ein positives Potential und gleichzeitig die Spannung Vca auf einen leicht negativen Wert gebracht. Dieses hat zur Folge, dass sich die Spannung auf einem Speicherkondensator C1 auf circa die Schwellspannung des Treibertransistors einstellt. Wird nun über einen Transistor T1 dieser mit der Datenleitung verbunden, liegt dann auch dort diese Spannung an und es muss nur noch die eigentliche Vdata Spannung hinzu addiert werden. Nachdem alle Bildelemente mit neuen Werten beschrieben sind, wird die Spannung Vca wieder auf das normale Betriebspotential eingestellt, und die OLED leuchtet proportional zur eingestellten Spannung Vdata.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

**Bezugszeichenliste**

| | |
|---|---|
| 1 | Ansteuertransistor |
| 2 | Datensignalleitung |

| | |
|---|---|
| 3 | Zeilenwahlleitung |
| 4 | Kondensator |
| 5 | Treibertransistor |
| 6 | organische Leuchtdiode (OLED) |
| 7 | Versorgungsleitung |
| 11, 31, 51 | Träger (Substrat) |
| 12, 38, 58 | Isolationsschicht |
| 13, 35, 55 | Kanal in Treiberschaltung |
| 14, 37, 57 | Source |
| 15, 36, 56 | Drain |
| 16, 34, 54 | Gate-Isolation |
| 17, 32, 52 | Gate |
| 18 | Passivierungsschicht |
| 19, 39 | Kathode |
| 20, 40, 64 | dotierte Elektronentransportschicht |
| 21, 42, 62 | Emitterschicht |
| 22, 44, 60 | dotierte Löchertransportschicht |
| 23, 45 | semitransparente Anode |
| 24 | Durchkontaktierung |
| 41, 63 | elektronenseitige Blockschicht |
| 42, 61 | löcherseitige Blockschicht |
| 59 | Anode |
| 65 | semitransparente Kathode |

**Patentansprüche**

1. Bildelement für eine Aktiv-Matrix-Anzeige mit einer organischen Leuchtdiode (OLED) (19-23; 39-45; 59-65) und einer Treiberschaltung mit einem die Leuchtdiode (19-23; 39-45; 59-65) ansteuernden Treibertransistor und einem Kondensator, wobei ein stromführender Pfad des Treibertransistors in Reihe mit der Leuchtdiode (19-23; 39-45; 59-65) und zumindest mittelbar zwischen zwei Pole einer Betriebsspannungsquelle geschaltet ist, **dadurch gekennzeichnet, dass** eine Transportschicht (20; 40; 60) der Leuchtdiode (19-23; 39-45; 59-65) eine die elektrische Leitfähigkeit der Transportschicht (20; 40; 60) erhöhende Dotierung aufweist und mit dem Drain-Kontakt (15; 36; 56) des Treibertransistors elektrisch verbunden ist.

2. Bildelement nach Anspruch 1, **dadurch gekennzeichnet, dass** die Transportschicht (20; 40; 60) über eine flächige Elektrode (19; 39; 59) mit dem Drain-Kontakt (15; 35; 55) des Treibertransistors verbunden ist.

3. Bildelement nach Anspruch 1, **dadurch gekennzeichnet, dass** die Transportschicht (20; 40; 60) direkt mit dem Drain-Kontakt (15; 35; 55) des Treibertransistors verbunden ist.

4. Bildelement nach einem der vorangehenden Ansprüche, **dadurch gekennzeichnet, dass** die Treiberschaltung eine weiteren Transistor umfaßt, der als ein Ansteuertransistor ausgebildet ist.

5. Bildelement nach einem der vorangehenden Ansprüche, **dadurch gekennzeichnet, dass** eine weitere Transportschicht (22; 44; 64) der Leuchtdiode (19-23; 39-45; 59-65) eine die elektrische Leitfähigkeit der weiteren Transportschicht (22; 44; 64) erhöhende Dotierung aufweist.

6. Bildelement nach einem der vorangehenden Ansprüche, **dadurch gekennzeichnet, dass** die Transportschicht (20; 40) oder die weitere Transportschicht (64) der Leuchtdiode (19-23; 39-45; 59-65) mit einem n-Dotanden n-dotiert ist.

7. Bildelement nach Anspruch 6, **dadurch gekennzeichnet, dass** der n-Dotand ein molekularer Dotand mit einer Molekülmasse größer als etwa 200 g/mol ist.

8. Bildelement nach Anspruch 6 oder 7, **dadurch gekennzeichnet, dass** der n-Dotand Pyronin B, Leukokristallviolett oder die Leukobase eines anderen kationischen Farbstoffs ist.

**9.** Bildelement nach Anspruch 6, **dadurch gekennzeichnet, dass** die n-dotierte Transportschicht (20; 40) oder die n-dotierte weitere Transportschicht (64) aus Lithium-dotiertem 4,7-Diphenyl-1,10-phenanthrolin gebildet ist, wobei ein molekulares Mischungsverhältnis von 4,7-Diphenyl-1,10-phenanthrolin (Bphen) : Lithium (Li) zwischen etwa 10 : 1 und etwa 1 : 3 liegt.

**10.** Bildelement nach Anspruch 6, **dadurch gekennzeichnet, dass** die n-dotierte Transportschicht (20; 40) oder die n-dotierte weitere Transportschicht (64) aus Lithium-dotiertem 4,7-Diphenyl-1,10-phenanthrolin gebildet ist, wobei das molekulare Mischungsverhältnis von 4,7-Diphenyl-1,10-phenanthrolin (Bphen) : Lithium (Li) zwischen etwa 5 : 1 und etwa 1 : 2 liegt.

**11.** Bildelement nach Anspruch 6, **dadurch gekennzeichnet, dass** die n-dotierte Transportschicht (20; 40) oder die n-dotierte weitere Transportschicht (64) aus Lithium-dotiertem 4,7-Diphenyl-1,10-phenanthrolin gebildet ist, wobei das molekulare Mischungsverhältnis von 4,7-Diphenyl-1,10-phenanthrolin (Bphen) : Lithium (Li) etwa 1 : 1 ist.

**12.** Bildelement nach einem der vorangehenden Ansprüche, **dadurch gekennzeichnet, dass** die Transportschicht (60) oder die weitere Transportschicht (22; 44) der Leuchtdiode (19-23; 39-45; 59-65) mit einem organischen Akzeptormaterial p-dotiert ist

**13.** Bildelement nach Anspruch 12, **dadurch gekennzeichnet, dass** die p-dotierte Transportschicht (60) oder die p-dotierte weitere Transportschicht (22; 44) aus Starburst 4,4,4-Tris(3-methylphenylphenylamino) triphenyl-amin (m-MTDATA) ist und mit einem bis etwa 80°C thermisch stabilen 2,3,5,6-Tetrafluoro-7,7,8,8-tetracyano-$p$-chinodi-methan-($F_4$-TCNQ)-Dotanden oder einem 1,6-Diaminopyren-(DAP)-$F_4$-TCNQ-Dotanden p-dotiert ist.

**14.** Bildelement nach Anspruch 12, **dadurch gekennzeichnet, dass** die p-dotierte Transportschicht (60) oder die p-dotierte weitere Transportschicht (22; 44) aus Starburst 4,4,4-Tris(3-methylphenylphenylamino)triphenyl-amin (m-MTDATA) ist und mit einem bis etwa 80 °C thermisch stabilen 2,3,5,6-Tetrafluoro-7,7,8,8-tetracyano-$p$-chin-odimethan-($F_4$-TCNQ)-Dotanden oder einem 1,6-Diaminopyren- (DAP) -$F_4$-TCNQ-Dotanden in einem Mischungsverhältnis im Bereich von etwa 1000 : 1 bis etwa 10 : 1 p-dotiert ist.

**15.** Bildelement nach Anspruch 12, **dadurch gekennzeichnet, dass** die p-dotierte Transportschicht (60) oder die p-dotierte weitere Transportschicht (22; 44) aus Starburst 4,4,4-Tris(3-methylphenylphenylamino)triphenyl-amin (m-MTDATA) ist und mit einem bis etwa 80 °C thermisch stabilen 2,3,5,6-Tetrafluoro-7,7,8, 8-tetracyano-$p$-chin-odimethan- ($F_4$-TCNQ)-Dotanden oder einem 1,6-Diaminopyren-(DAP)-$F_4$-TCNQ-Dotanden in einem Mischungsverhältnis im Bereich von etwa 100 : 1 bis etwa 20 : 1 p-dotiert ist.

**16.** Bildelement nach einem der vorangehenden Ansprüche, **dadurch gekennzeichnet, dass** der Treibertransistor ein n-Kanal-Transistor ist, die Leuchtdiode (19-23; 39-45) zwischen den Drain-Kontakt (15; 36) des Treibertransistors und einen positiven Pol der Betriebsspannungsquelle geschaltet ist, der Treibertransistor auf einer einer Kathode (19; 39) der Leuchtdiode (19-23; 39-45) zugewandten Seite angeordnet ist und der Kondensator mit einem Gate-Kontakt (17; 32) und einem Source-Kontakt (15; 37) des Treibertransistors verbunden ist.

**17.** Bildelement nach einem der Ansprüche 1 bis 15, **dadurch gekennzeichnet, dass** der Treibertransistor ein p-Kanal-Transistor ist, die Leuchtdiode (59-65) zwischen den Drain-Kontakt (56) des Treibertransistors und einen negativen Pol der Betriebsspannungsquelle geschaltet ist, der Treibertransistor auf einer einer Anode (59) der Leuchtdiode (59-65) zugewandten Seite angeordnet ist und der Kondensator mit einem Gate-Kontakt (52) und einem Source-Kontakt (57) des Treibertransistors verbunden ist.

**18.** Bildelement nach einem der vorangehenden Ansprüche, **dadurch gekennzeichnet, dass** die Treiberschaltung drei Transistoren aufweist und schwellspannungskompensierend ausgführt ist.

**19.** Bildelement nach einem der Ansprüche 1 bis 17, **dadurch gekennzeichnet, dass** die Treiberschaltung vier Transistoren in einer Stromspiegel-Anordnung aufweist, wobei der Treibertransistor als Teil der Stromspiegel-Anordnung gebildet ist.

**20.** Bildelement nach einem der vorangehenden Ansprüche, **dadurch gekennzeichnet, dass** die Transistoren der Treiberschaltung als Dünnschichttransistoren gebildet sind.

**21.** Bildelement nach einem der vorangehenden Ansprüche, **dadurch gekennzeichnet, dass** die Leuchtdiode (19-23;

39-45; 59-65) eine transparente organische Leuchtdiode (TOLED) ist.

22. Bildelement nach einem der vorangehenden Ansprüche, **dadurch gekennzeichnet, dass** die Treiberschaltung und die Leuchtdiode (19-23; 39-45; 59-65) auf einem gemeinsamen Substrat (11; 31; 51) gebildet sind, wobei die Treiberschaltung zwischen der Leuchtdiode (19-23; 39-45; 59-65) und dem gemeinsamen Substrat (11; 31; 51) angeordnet ist und wobei die Leuchtdiode (19-23; 39-45; 59-65) als Top-Emitter-OLED mit einer vom gemeinsamen Substrat (11; 31; 51) weg gerichteten Leuchtrichtung gebildet ist.

23. Bildelement nach einem der vorangehenden Ansprüche, **dadurch gekennzeichnet, dass** eine Kontaktierung des Drain-Kontaktes (15; 36; 56) des Treibertransistor mittels einer organischmetallischen Kompositschicht erfolgt.

24. Bildelement nach Anspruch 23, **dadurch gekennzeichnet, dass** die Kompositschicht mittels Beimischung einer oder mehrerer Substanzen eine elektrische Dotierung aufweist.

25. Bildelement nach einem der vorangehenden Ansprüche, **dadurch gekennzeichnet, dass** wenigstens eine die Reflexion erhöhende Schicht zwischen der Treiberschaltung und der Leuchtdiode angeordnet ist.

26. Bildelement nach Anspruch 25, **dadurch gekennzeichnet, dass** die wenigstens eine die Reflexion erhöhende Schicht aus einem oder mehreren Metallen ist.

27. Bildelement nach Anspruch 25, **dadurch gekennzeichnet, dass** die wenigstens eine die Reflexion erhöhende Schicht aus einem oder mehreren dielektrischen Materialien ist.

28. Bildelement nach einem der vorangehenden Ansprüche, **dadurch gekennzeichnet, dass** wenigstens eine die Reflexion vermindernde Schicht zwischen der Treiberschaltung und der Leuchtdiode angeordnet ist.

29. Bildelement nach Anspruch 28, **dadurch gekennzeichnet, dass** die wenigstens eine die Reflexion vermindernde Schicht eine organisch-metallische Kompositschicht ist.

30. Bildelement nach Anspruch 28, **dadurch gekennzeichnet, dass** die wenigstens eine die Reflexion vermindernde Schicht aus einem oder mehreren dielektrischen Materialien ist.

2

3

7

6

5

1

4

## Fig. 1

23

21
20
19
11

22
24
18
16
12

14  13  17  15

## Fig. 2

**Fig. 3**

**Fig. 4**

Fig. 5

Fig. 6

**Fig. 7**

**Fig. 8**